Europäisches Patentamt

(19) European Patent Office

Office européen des brevets

(11) Veröffentlichungsnummer: **0 002 688**
**B1**

(12) EUROPÄISCHE PATENTSCHRIFT

(45) Veröffentlichungstag der Patentschrift:
04.11.81

(51) Int. Cl.³: **H 01 J 37/08,** H 01 J 37/04

(21) Anmeldenummer: 78101564.9

(22) Anmeldetag: 05.12.78

(54) **Apparat zur Bestahlung einer Auffangfläche mit Ionen.**

(30) Priorität: 29.12.77 US 865652

(43) Veröffentlichungstag der Anmeldung:
11.07.79 Patentblatt 79/14

(45) Bekanntmachung des Hinweises auf die Patenterteilung:
04.11.81 Patentblatt 81/44

(84) Benannte Vertragsstaaten:
DE FR GB NL

(56) Entgegenhaltungen:
ELECTRONIQUE & MICROELECTRONIQUE
INDUSTRIELLES, NR. 141, 1971,
Seiten 31 – 37, Sociéte du Editions
Radio, Paris, FR
DELECTROIX» Implantation ionique
principes et applications«,
Figuren 6, 7; Seiten 33 – 34
SOVIET JOURNAL OF OPTICAL
TECHNOLOGY; Vol. 41, Nr. 9
September 1974,
New York, USA,
ZHDANOV »A self-cleaning electron
microscope aperture diaphragm«,
Seiten 437, 438

(73) Patentinhaber: International Business Machines
Corporation, Armonk, N.Y. 10504 (US)

(72) Erfinder: Hicks, William Wallace, 26 Lake Oniad Drive,
Wappingers Falls N.Y. 12590 (US)
Erfinder: Keller, John Howard, 7 Dutchess Court,
Newburgh N.Y. 12550 (US)
Erfinder: Koestner, Joseph Henry, 5 Creamery Road,
Hopewell Junction N.Y. 12533 (US)

(74) Vertreter: Kirchhof, Norbert, Ing. grad., Schönaicher
Strasse 220, D-7030 Böblingen (DE)

## Apparat zur Bestrahlung einer Auffangfläche mit Ionen

Die Erfindung bezieht sich auf einen Apparat zur Bestrahlung einer Auffangfläche mit Ionen, mit Strahlformmitteln entlang des Weges von der Ionenquelle zur Auffangfläche.

Apparate zur Ionenimplantation wurden zur Herstellung von LSI-Halbleiterschaltkreisen ausgebildet. Bei bekannten Vorrichtungen zur Ionenimplantation zwecks Dotierung von Halbleiterplättchen wird dem von einer Ionenquelle emittierten Ionenstrahl durch eine Mehrzahl von in bekannter Weise angeordneten Strahlformgliedern eine bestimmte Querschnittsform erteilt und dieser auf das Ziel gerichtet. Von diesen Gliedern wird das Strahlformglied, das der Strahl nach Verlassen der geheizten Ionenquelle passiert, Beschleunigungsplatte genannt. Üblicherweise ist die Beschleunigungsplatte dick und starr genug, um Befestigungsflächen für Befestigungsmittel für eine Ionenextraktionseinrichtung anzubieten, und weist Strahlformöffnungen auf. Bisher wurden keine Überlegungen bezüglich der Anordnung und/oder Ausbildung der Beschleunigungsplatte angestellt, um diese auf einer bestimmten hohen Temperatur zu halten. Es wurde festgestellt, daß übliche Apparate mit einer zwei mm dicken Kupferplatte als Beschleunigungsplatte die letztere nicht auf einer Temperatur halten können, die über dem Kondensationspunkt des Implantatdampfes liegt, wegen der hohen thermischen Masse der dicken Platte und dem niedrigen Strahlungsemissionsvermögen des Kupfers. Wenn beispielsweise mit diesem Apparat ein Material wie Arsen im Dampfzustand zu implantieren ist, wird es in unerwünschter Weise nach dem Verlassen der erwärmten Ionenquelle an der ersten kühlen Oberfläche, das ist die Beschleunigungsplatte, niedergeschlagen. Es wurde auch festgestellt, daß solche Niederschläge nach einer bestimmten Zeitdauer abzublättern beginnen und einen Lichtbogen zwischen der Ionenquelle und der Beschleunigungsplatte verursachen, wodurch der Betrieb des Apparates wesentlich beeinträchtigt wird. Ein Versuch das Lichtbogenproblem zu eliminieren, besteht in einem häufigen Reinigen der Beschleunigungsplatte, um die Beschläge zu entfernen. Dies ist nicht nur unter dem Blickwinkel der Standzeit der Vorrichtung unerwünscht, sondern stellt auch infolge der Reinigungsfrequenz ein erhöhtes Sicherheitsrisiko dar.

Die Erfindung, wie sie in den Ansprüchen gekennzeichnet ist, löst die Aufgabe, einen Apparat zur Bestrahlung einer Auffangfläche mit Ionen zu schaffen, bei dem das Strahlformglied frei von Niederschlägen und Ansammlungen des verdampften Materiales gehalten wird.

Die durch die Erfindung erreichten Vorteile sind im wesentlichen darin zu sehen, daß die von der Ionenquelle abgestrahlte Strahlungswärme durch das Strahlformglied aus einem Material von vorzugsweise hohem Strahlungsemissionsvermögen absorbiert wird, das dadurch schnell auf eine Temperatur über den Kondensationspunkt erwärmt wird. Das Strahlformglied ist vorzugsweise eine Platte von 0,25 mm Dicke und besteht aus Tantal, das ein Strahlungsemissionsvermögen von ungefähr 0,5 aufweist. Es sind auch andere Materialien, wie Graphit, Titan und Wolfram, verwendbar, die ein Strahlungsemissionsvermögen aufweisen, das größer als 0,4 und kleiner als 1,0 ist. Um die Platte auf der genannten Temperatur zu halten, kann ein Stützkörper aus einem Hochtemperatur-Isoliermaterial, wie Keramik, vorgesehen sein oder ein Stützkörper aus Metall ist durch einen kleinen Spalt von der Platte getrennt, um deren Wärmeleitung zum Stützkörper zu vermindern. Der Spalt vermeidet eine unerwünschte Wärmeabfuhr, besonders wenn der Stützkörper aus Metall ist und gestattet der reflektierenden Oberfläche des Stützkörpers die Strahlung zurück zur dünnen Platte zu reflektieren. Dies führt zu einer Stabilisierung der Betriebstemperatur der dünnen Platte. Vorzugsweise ist der Stützkörper aus Kupfer, jedoch ein anderes Material mit niedrigem Strahlungsemissionsvermögen, wie Edelstahl oder Keramik, ist ebenfalls verwendbar. Alternativ kann der Stützkörper aus einer Mehrzahl von Schichten aufgebaut sein, um einen Strahlungsschild zu bilden.

Weitere Einzelheiten der Erfindung sind nachstehend anhand eines in den Figuren veranschaulichten Ausführungsbeispieles beschrieben.

Es zeigt

Fig. 1 ein Schema eines Ionenimplantationsapparates mit entsprechend der Erfindung ausgebildeten Strahlformgliedern und

Fig. 2 einen Schnitt der Strahlformglieder nach Fig. 1.

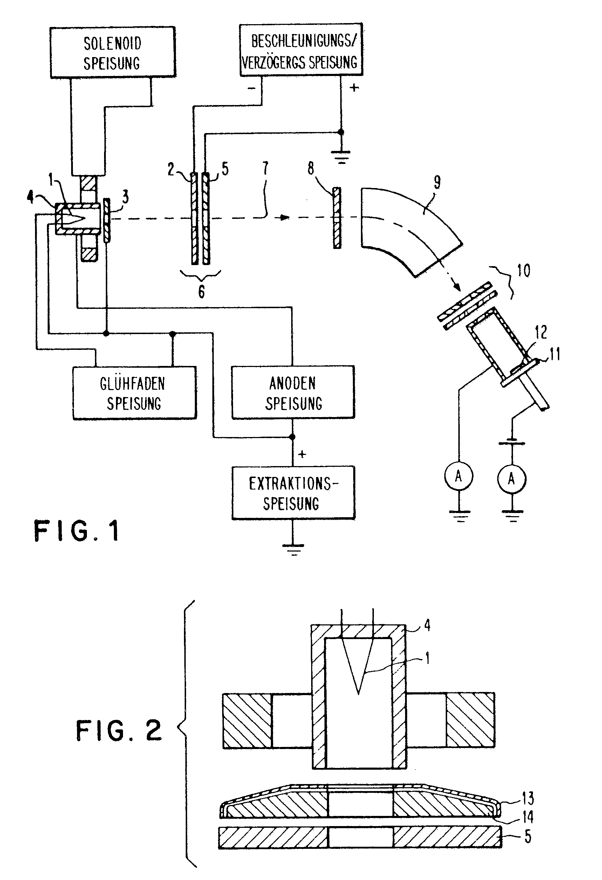

Die Strahlformglieder werden im Hinblick auf Beschleunigungs- bzw. Verzögerungslieder eines Ionenimplantationsapparates beschrieben. Es ist jedoch klar, daß die Erfindung ebenso anwendbar ist bei ähnlichen Gliedern irgendeines anderen Ionen erzeugenden bzw. verwendenden Apparates. Der in Fig. 1 gezeigte Apparat ist ein konventioneller Ionenimplantationsapparat. Er enthält die konventionelle Ionenquelle 1, die irgendeine geeignete Quelle hoher Dichte sein kann, obwohl eine heiße Fadenelektronenquelle gezeigt ist, die oszillierend Elektronen ausstößt. Ein Dampf, aus dem die Ionen, die zu implantieren sind, erzeugt werden soll, wird der Ionenquelle 1 von einer nicht gezeigten, externen Versorgung zugeführt. Aus der Ionenquelle 1 wird in konventioneller Art mit Hilfe der Ionenextraktionselektrode 2 über die Öffnung 3 ein Ionenstrahl entnommen. Die Elektrode 2 wird Beschleunigungselektrode genannt und durch eine Beschleunigungs- bzw. Verzögerungsspannungsversorgung auf einem, negativen Potential gehalten, um Ionen aus der Ionenquelle heraus-

zuziehen. Andererseits wird die Ionenquellen-elektrode 4 durch die Extraktionsversorgung auf einem positiven Potential gehalten. Eine andere Platte der Strahlformglieder, Verzögerungselektrode 5 genannt, ist gegenüber der Beschleunigungselektrode 2 angeordnet und wird auf Erdpotential gehalten. Die Beschleunigungselektrode 2 und die Verzögerungselektrode 5 weisen eine Öffnung irgendeiner gewünschten Form, im vorliegenden Fall von Schlitzform auf. Die Vorspannung und die Form der Öffnungen sind während des Betriebes des Apparates variierbar.

Der aus der Ionenquelle 1 mittels der beschriebenen Elektrodenanordnung herausgezogene Strahl wird entlang des Strahlweges 7 zu dem Analysiermagnet 9 von konventioneller Ausführung geführt. Der Strahl wird weiter in konventioneller Art durch die gelochten Platten 8 und 10 geformt, die auf jeder Seite des Magneten 9 angeordnet sind. Der so geformte Strahl wird gegen die Auftrefffläche 11 gelenkt, auf der das Halbleiterplättchen 12 befestigt ist.

In Fig. 2 ist die selbstreinigende Ausführung eines Strahlformgliedes gemäß der Erfindung dargestellt. Die Beschleunigungselektrode 2 umfaßt eine dünne Beschleunigungsplatte 13 aus einem Material von hohem Strahlungsemissionsvermögen, die eine geringe Wärmekapazität besitzt, und einen Stützkörper 14 aus einem Material mit niedrigem Strahlungsemissionsvermögen. Vorzugsweise besteht die Beschleunigungsplatte aus Tantal mit einer Dicke von 0,25 mm, d. h. sie ist um eine Größenordnung dünner als eine konventionelle Kupferelektrode. Das Strahlungsemissionsvermögen von Tantal beträgt ungefähr 0,5, gegenüber 0,1 von Kupfer. Es soll betont werden, daß die zuvor beschriebenen Ausführungen und Materialien lediglich illustrativen Zwecken dienen und von der besonderen Ausführung des Apparates, seiner Wirkungsweise usw. abhängen. Zwischen der Platte 13 und dem Stützkörper 14 aus Kupfer ist ein schmaler Zwischenraum vorgesehen. Die Platte 13 ist mit dem Stützkörper 14 durch nicht gezeigte Schrauben aus Edelstahl verbunden, und da die beiden Teile keine ebenen Flächen aufweisen, ist zwischen ihnen lediglich ein Punktkontakt vorhanden, der den genannten Zwischenraum zuläßt. Dieser Zwischenraum der wünschenswert, jedoch nicht notwendig ist, dient zur wirkungsvollen Reduzierung der Wärmeleitung zwischen der Platte und dem Stützkörper. Der Stützkörper trägt zur Stabilisierung der Betriebstemperatur der Beschleunigungsplatte bei, verleiht der Einheit eine gewisse Stärke und weist die Befestigungsflächen für Anschlüsse an weitere Einrichtungen auf. Es ist zu erwähnen, daß irgendwelche anderen Materialien statt Kupfer für den Stützkörper verwendbar sind, wenn sie die Wärmeleitung und Strahlung von der Rückseite der dünnen Platte unterbinden und zur Stabilisierung der Betriebstemperatur der Platte beitragen. Diese kann durch ihre Reflexionsfähigkeit, wie bei Kupfer oder infolge geringer thermischer Leitfähigkeit wie bei Keramik, oder durch beide Eigenschaften, wie bei Edelstahl geschehen.

Die von der innerhalb der Ionenquellenelektrode 4 angeordnete Ionenquelle 1 ausgestrahlte Wärme erreicht eine Fläche der Beschleunigungsplatte 13 und führt derselben Wärmeenergie zu. Diese Strahlungswärme erlaubt ein schnelles Aufheizen der Tantalplatte 13 infolge des hohen Strahlungsemissionsvermögens des Tantals und der niedrigen thermischen Kapazität dieser dünnen Platte. Die hohe Zurückstrahlung und/oder die geringe Wärmeleitung des Stützkörpers 14 und der Zwischenraum zwischen den gegenüberliegenden reflektierenden Flächen halten die Platte 13 auf einer Temperatur, die hoch genug ist, um ein Niederschlagen des Dampfes an der Oberfläche der Platte 13 zu verhindern. Der Stützkörper 14 trägt durch sein niedriges Strahlungsemissionsvermögen zur Begrenzung der Strahlungswärme bei, welche die Platte 13 empfängt, stabilisiert die Betriebstemperatur der Beschleunigungselektrode und bildet einen mechanischen Träger. Der in Fig. 2 gezeigte Aufbau der Beschleunigungselektrode verwendet die von der Ionenquelle ausgestrahlte Wärme für das Erreichen einer Temperatur, die ausreicht, um die Elektrode rein zu halten und diese kann somit als selbstreinigend bezeichnet werden.

**Patentansprüche**

1. Apparat zur Bestrahlung einer Auffangfläche mit Ionen, mit Strahlformmitteln entlang des Weges von der Ionenquelle zur Auffangfläche, dadurch gekennzeichnet, daß ein Strahlformglied (13) mit einer Strahlformöffnung die von der Ionenquelle (1) ausgestrahlte Wärme absorbiert und daß Mittel (14) vorgesehen sind, die das genannte Strahlformglied (13) auf einer Temperatur halten, die über dem Kondensationspunkt des von der Ionenquelle (1) ausgesandten Dampfes liegt.

2. Apparat nach Anspruch 1, dadurch gekennzeichnet, daß das Strahlformglied (13) aus Tantal besteht.

3. Apparat nach Anspruch 1, dadurch gekennzeichnet, daß die Mittel zur Aufrechterhaltung der Temperatur des Strahlformgliedes (13) über dem Kondensationspunkt aus einem Stützkörper (14) aus einem Material mit gegenüber dem des Strahlformgliedes niedrigerem Strahlungsemissionsvermögen und/oder geringerer Wärmeleitfähigkeit bestehen.

4. Apparat nach Anspruch 3, dadurch gekennzeichnet, daß der Stützkörper (14) vom Strahlformglied (13) beabstandet ist.

5. Apparat nach Anspruch 3, dadurch gekennzeichnet, daß der Stützkörper (14) aus einem Isoliermaterial besteht.

6. Apparat nach Anspruch 4, dadurch gekennzeichnet, daß der Stützkörper (14) aus einem Material der Gruppe Kupfer, Edelstahl und Keramik besteht.

7. Apparat nach Anspruch 6, dadurch gekennzeichnet, daß das Strahlformglied (13) aus einem Material der Gruppe Tantal, Titan und Graphit besteht.

8. Apparat nach Anspruch 1, dadurch gekennzeichnet, daß Strahlformglied (13) und Stützkörper (14) eine Beschleunigungselektrode (2) bilden.

9. Apparat nach Anspruch 7, dadurch gekennzeichnet, daß der Dampf Arsen enthält.

**Claims**

1. Apparatus for irradiating a target with ions, having beam shaping means along the path from the ions source to said target, characterized in that a beam-shaping member (13) with a beam-shaping aperture absorbs radiant heat from said ion source (1) and that means (14) are provided for maintaining said beam-shaping member (13) at a temperature above the condensation point of vapor emanating from said ion source (1).

2. Apparatus according to claim 1, characterized in that said beam-shaping member (13) comprises tantalum.

3. Apparatus according to claim 1, characterized in that said means for maintaining the temperature of said beam-shaping member (13) above the condensation point comprise a support (14) of a material having lower spectral emissivity and/or poorer thermal conductivity than that of said beam-shaping member.

4. Apparatus according to claim 3, characterized in that said support (14) is spaced from said beam-shaping member (13).

5. Apparatus according to claim 3, characterized in that said support (14) ist formed of an insulative material.

6. Apparatus according to claim 4, characterized in that said support (14) is formed of a material selected from the group consisting of copper, stainless steel and ceramic.

7. Apparatus according to claim 6, characterized in that said beam-shaping member (13) is formed of a material selected from the group consisting of tantalum, titanium and graphite.

8. Apparatus according to claim 1, characterized in that said beam-shaping member (13) and said support (14) form an acceleration electrode (2).

9. Apparatus according to claim 7, characterized in that the vapor includes arsenic.

**Revendications**

1. Appareil pour irradier une cible avec des ions, comportant des moyens de mise en forme des faisceaux le long du trajet de la source d'ions à la cible, caractérisé en ce qu'un élément de mise en forme de faisceaux (13) avec une ouverture de mise en forme de faisceaux absorbe la chaleur émise par la source d'ions (1) et en ce que l'on prévoit des moyens (14) pour maintenir ledit élément de mise en forme de faisceaux (13) à une température au-dessus du point de condensation de la vapeur émanant de la source d'ions (1).

2. Appareil selon la revendication 1, caractérisé en ce que l'élément de mise en forme de faisceaux (13) est composé de tantale.

3. Appareil selon la revendication 1, caractérisé en ce que les moyens pour maintenir la température de l'élément de mise en forme de faisceaux (13) au-dessus du point de condensation sont composés d'un support (14) d'un matériau ayant un pouvoir d'émission de rayonnement et/ou une conductivité de chaleur plus faible que celle de l'élément de mise en forme de faisceaux.

4. Appareil selon la revendication 3, caractérisé en ce que le support (14) est espacé de l'élément de mise en forme de faisceaux (13).

5. Appareil selon la revendication 3, caractérisé en ce que le support (14) est composé d'un matériau isolant.

6. Appareil selon la revendication 4, caractérisé en ce que le support (14) est composé d'un matériau du groupe comprenant le cuivre, l'acier spécial et la céramique.

7. Appareil selon la revendication 6, caractérisé en ce que l'élément de mise en forme de faisceaux (13) est composé d'un matériau du groupe comprenant le tantale, le titane et la graphite.

8. Appareil selon la revendication 1, caractérisé en ce que l'élément de mise en forme de faisceaux (13) et le support (14) forment une électrode d'accélération (2).

9. Appareil selon la revendication 7, caractérisé en ce que la vapeur contient de l'arsenic.

SOLENOID SPEISUNG

BESCHLEUNIGUNGS/ VERZÖGERGS SPEISUNG

GLÜHFADEN SPEISUNG

ANODEN SPEISUNG

EXTRAKTIONS- SPEISUNG

FIG. 1

FIG. 2